(19) 

Europäisches
Patentamt
European
Patent Office
Office européen
des brevets

(11) **EP 2 011 232 B1**

(12) **EUROPEAN PATENT SPECIFICATION**

(45) Date of publication and mention
of the grant of the patent:
**03.08.2011 Bulletin 2011/31**

(21) Application number: **06809694.0**

(22) Date of filing: **24.10.2006**

(51) Int Cl.:
***H03F 1/32*** (2006.01)

(86) International application number:
**PCT/IB2006/053917**

(87) International publication number:
**WO 2007/122457 (01.11.2007 Gazette 2007/44)**

(54) **ADAPTIVE PRE-DISTORTION**

ADAPTIVE VORVERZERRUNG

PRÉDISTORSION ADAPTIVE

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **24.04.2006 US 379891**

(43) Date of publication of application:
**07.01.2009 Bulletin 2009/02**

(73) Proprietor: **Sony Ericsson Mobile
Communications AB
221 88 Lund (SE)**

(72) Inventors:
• **JORGENSEN, Filip
224 71 Lund (SE)**

• **ERIKSSON, Joakim
222 29 Lund (SE)**

(74) Representative: **VALEA AB
Lindholmspiren 5
417 56 Göteborg (SE)**

(56) References cited:
**EP-A- 1 523 102          WO-A-01/05026
WO-A-97/30521          WO-A-03/019773
WO-A-2005/072331      GB-A- 2 337 169
GB-A- 2 408 160          US-A1- 6 141 390
US-A1- 2002 050 372  US-A1- 2005 104 658
US-A1- 2005 163 268**

EP 2 011 232 B1

**Description**

BACKGROUND OF THE INVENTION

Technical Field of the Invention

Implementations described herein relate generally to signal conditioning, and more particularly to conditioning a signal input to a device, such as an amplifier.

Description of Related Art

Devices, such as mobile communication devices, may use power amplifiers to amplify signals. For example, a mobile communication device may use a power amplifier to amplify a baseband signal, such as speech, or a modulated signal, such as modulated baseband signal, before providing the signal to a transmitting device, such as an antenna. Power amplifiers may distort an input signal when the input signal is amplifed.

Designers may attempt to compensate for amplifier distortion when the amplifier is manufactured. Compensating for amplifier distortion at manufacture may not account for power amplifier characteristics that can change over time. For example, silicon used to support electronic components used to amplify a signal in the power amplifier may change as the silicon ages. In addition, operating environments that the power amplifier is used in may cause amplifier characteristics to change. For example, a power amplifier may have a first characteristic when the amplifier is operated at a first temperature and a second characteristic when the amplifier is operated at a second temperature.

Changes in power amplifier characteristics may cause changes to distortion produced by the power amplifier. As a result, manufacturing-side distortion compensation may not be useful once the power amplifier is in use within a device. For example, an output of a power amplifier may change as the power amplifier is used, e.g., as the power amplifier ages. Over time, output characteristics of the power amplifier may become distorted to a point where the power amplifier's output is out of specification. An out of specification output may cause a device, such as a mobile communication device, to not be recognized by a network within which the mobile communication device is attempting to operate.

International publication no. WO 01/05026 concerns a predistortion system that comprises a digital compensation signal processing component (DCSP) which predistorts a wideband input transmission signal to compensate for the frequency and time dependent AM-AM and AM-PM distortion characteristics of a non-linear amplifier. The DCSP comprises a data structure in which each element stores a set of compensation parameters (preferably including FIR filter coefficients) for predistorting the input transmission signal. The parameter sets are preferably indexed within the data structure according to multiple signal characteristics, such as instantaneous amplitude and integrated signal envelope, each of which corresponds to a respective dimension of the data structure. To predistort the input transmission signal, an addressing circuit digitally generates a set of data structure indices from the input transmission signal, and the indexed set of compensation parameters is loaded into a compensation circuit which digitally predistorts the input transmission signal. This process of loading new compensation parameters into the compensation circuit is preferably repeated every sample instant, so that the predistortion function varies from sample-to-sample. The sets of compensation parameters are generated periodically and written to the data structure by an adaptive control processing and compensation estimator (ACPCE) that performs a non-real-time analysis of amplifier input and output signals. The ACPCE also implements various system identification processes for measuring the characteristics of the power amplifier and generating initial sets of filter coefficients. In an antenna array embodiment, a single ACPCE generates the compensation parameters sets for each of multiple amplification chains on a time-shared basis. In an embodiment in which the amplification chain includes multiple nonlinear amplifiers that can be individually controlled (e.g., turned ON and OFF) to conserve power, the data structure separately stores compensation parameter sets for each operating state of the amplification chain.

BRIEF SUMMARY_OF THE INVENTION

According to one aspect, a device having the features cited in claim 1 is provided.

According to another aspect, a method having the steps recited in claim 7 is provided.

Preferred embodiments of said device and method are provided

in the accompanying set of claims.

BRIEF DESCRIPTION OF THE DRAWINGS

The accompanying drawings, which are incorporated in and constitute a part of this specification, illustrate an

2

embodiment of the invention and, together with the description, explain the invention. In the drawings,

Fig. 1 is a diagram of an exemplary implementation of a mobile terminal consistent with the principles of the invention;
Fig. 2 illustrates an exemplary functional diagram of a mobile terminal consistent with the principles of the invention;
Fig. 3 illustrates a block diagram of a first exemplary implementation of a communication interface consistent with the principles of the invention;
Fig. 4 illustrates a block diagram of a second exemplary implementation of a communication interface consistent with the principles of the invention;
Fig. 5 illustrates an exemplary data structure that can be used to store parameters related to a power amplifier consistent with the principles of the invention; and
Fig. 6 illustrates exemplary processing that can be used to compensate for power amplifier distortion consistent with the principles of the invention.

DETAILED DESCRIPTION OF THE INVENTION

The following detailed description of the invention refers to the accompanying drawings. The same reference numbers in different drawings may identify the same or similar elements. Also, the following detailed description does not limit the invention.

Implementations of the invention can be used to improve the operation of devices that employ power amplifiers. For example, a power amplifier may impart amplitude and/or phase distortion to a signal passing through the power amplifier. In one implementation, an input signal is measured prior to the power amplifier and an output signal is measured at an output of the power amplifier. An error signal is formed by processing the input signal and the output signal and the error signal is used to adaptively pre-distort the signal input to the power amplifier. The pro-distorted input signal is configured to account for errors introduced by the power amplifier so that an output signal of the power amplifier has desired characteristics.

Exemplary implementations of the invention will be described in the context of a mobile communications terminal. It should be understood that a mobile communication terminal is an example of one type of device that can employ adaptive power amplifier compensation techniques consistent with the principles of the invention and should not be construed as limiting the types of devices, or applications, that can use implementations of power amplifier compensation described herein. For example, power amplifiers, using adaptive compensation techniques described herein, may be used in non-wireless devices, such as appliances, industrial machines, automobile, desktop computers, etc. In addition, power amplifiers using adaptive compensation techniques described herein, may be used in wireless devices, such as laptops, personal digital assistants (PDAs), radios, cell phones, satellite radios, data telemetry devices, etc.

EXEMPLARY MOBILE TERMINAL

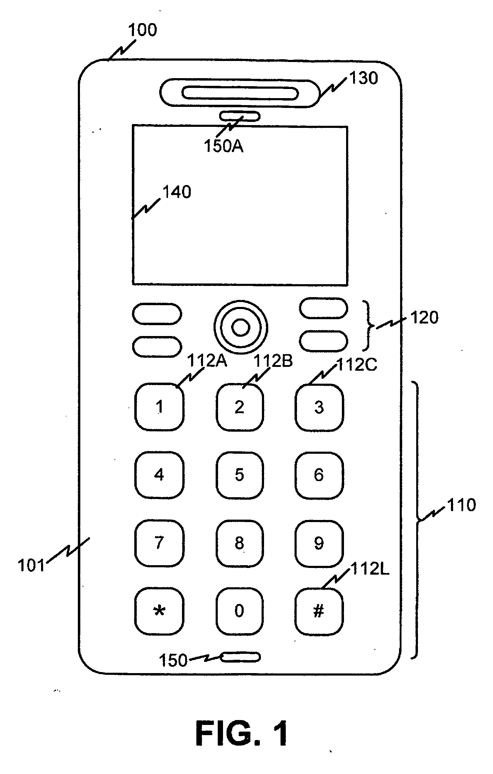

Fig. 1 is a diagram of an exemplary implementation of a mobile terminal consistent with the principles of the invention. Mobile terminal 100 (hereinafter terminal 100) may be a mobile communication device. As used herein, a "mobile communication device" and/or "mobile terminal" may include a radiotelephone; a personal communications system (PCS) terminal that may combine a cellular radiotelephone with data processing, a facsimile, and data communications capabilities; a PDA that can include a radiotelephone, pager, Internet/intranet access, web browser, organizer, calendar, and/or global positioning system (GPS) receiver; and a laptop and/or palmtop receiver or other appliance that includes a radiotelephone transceiver.

Terminal 100 may include housing 101, keypad 110, control keys 120, speaker 130, display 140, and microphones 150 and 150A. Housing 101 may include a structure configured to hold devices and components used in terminal 100. For example, housing 101 may be formed from plastic, metal, or another material and may be configured to support keys 112A-L (collectively keys 112), control keys 120, speaker 130, display 140 and microphone 150 or 150A.

Keypad 110 may include devices, such as keys 112A-L, that can be used to enter information into terminal 100. Keys 112 may be used in a keypad (as shown in Fig. 1), in a keyboard, or in some other arrangement of keys. Implementations of keys 112 may have key information associated therewith, such as numbers, letters, symbols, etc. A user may interact with keys 112 to input key information into terminal 100. For example, a user may operate keys 112 to enter digits, commands, and/or text, into terminal 100.

Control keys 120 may include buttons that permit a user to interact with terminal 100 to cause terminal 100 to perform an action, such as to display a text message via display 140, raise or lower a volume setting for speaker 130, etc. Speaker 130 may include a device that provides audible information to a user of terminal 100. Speaker 130 may be located in an upper portion of terminal 100 and may function as an ear piece or with an ear piece when a user is engaged in a communication session using terminal 100.

Display 140 may include a device that provides visual information to a user. For example, display 140 may provide information regarding incoming or outgoing calls, text messages, games, images, video, phone books, the current date/time, volume settings, etc., to a user of terminal 100.

Microphones 150 and/or 150A may, respectively, include a device that converts speech or other acoustic signals into electrical signals for use by terminal 100. Microphone 150 may be located proximate to a lower side of terminal 100 and maybe configured to convert spoken words or phrases into electrical signals for use by terminal 100. Microphone 150A may be located proximate to speaker 130 and may be configured to receive acoustic signals proximate to a user's ear while the user is engaged in a communications session using terminal 100. For example, microphone 150A may receive background noise and/or sound coming from speaker 130.

EXEMPLARY FUNCTIONAL DIAGRAM

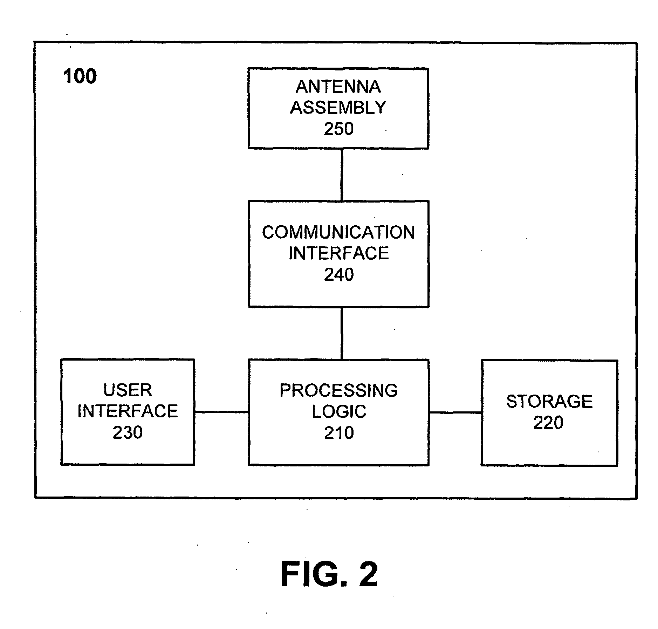

Fig. 2 illustrates an exemplary functional diagram of a mobile terminal consistent with the principles of the invention. As shown in Fig. 2, terminal 100 may include processing logic 210, storage 220, user interface 230, communication interface 240, and antenna assembly 250. Processing logic 210 may include a processor, microprocessor, an application specific integrated circuit (ASIC), field programmable gate array (FPGA), or the like. Processing logic 210 may include data structures or software programs to control operation of terminal 100 and its components. Storage 220 may include a random access memory (RAM), a read only memory (ROM), a magnetic or optical disk and its corresponding drive and/or another type of memory to store data and instructions that may be used by processing logic 210.

User interface 230 may include mechanisms for inputting information to terminal 100 and/or for outputting information from terminal 100. Examples of input and output mechanisms might include a speaker (e.g., speaker 130) to receive electrical signals and output audio signals, a microphone (e.g., microphone 150 or 150A) to receive audio signals and output electrical signals, buttons (e.g., control keys 120 and/or keys 112) to permit data and control commands to be input into terminal 100, a display (e.g., display 140) to output visual information, and/or a vibrator to cause terminal 100 to vibrate.

Communication interface 240 may include, for example, a transmitter that may convert baseband signals from processing logic 210 to radio frequency (RF) signals and/or a receiver that may convert RF signals from antenna assembly 250 to baseband signals. Alternatively, communication interface 240 may include a transceiver to perform functions of both a transmitter and a receiver. Communication interface 240 may connect to antenna assembly 250 for transmission and/or reception of the RF signals. Communication interface 240 may include one or more power amplifiers and may include adaptive power amplifier compensation logic that operates to maintain output characteristics of the one or more power amplifiers within a determined operating range, as described in detail below.

Antenna assembly 250 may include one or more antennas to transmit and receive RF signals over the air.

Antenna assembly 250 may receive RF signals from communication interface 240 and may transmit them over the air and receive RF signals over the air and may provide them to communication interface 240. Implementations of antenna assembly 250 may include a front end module that may include a switch for switching from one frequency to another and/or to switch from a transmit mode to a receive mode. Front end modules may also employ one or more filters that can be tuned to particular frequencies and/or frequency bands with which terminal 100 is configured to operate. In an alternative implementation of terminal 100, a front end module may be implemented in communication interface 240.

As will be described in detail below, terminal 100, consistent with the principles of the invention, may perform certain operations relating to adaptively compensating for operating characteristics of a power amplifier operating in terminal 100. Terminal 100 may perform these operations in response to processing logic 210 executing software instructions of a power amplifier compensation application contained in a computer-readable medium, such as storage 220. A computer-readable medium may be defined as a physical or logical memory device and/or carrier wave.

The software instructions may be read into storage 220 from another computer-readable medium or from another device via communication interface 240. The software instructions contained in storage 220 may cause processing logic 210 to perform processes that will be described later. Alternatively, hardwired circuitry may be used in place of or in combination with software instructions to implement processes consistent with the principles of the invention. Thus, implementations consistent with the principles of the invention are not limited to any specific combination of hardware circuitry and software.

EXEMPLARY COMMUNICATION INTERFACE

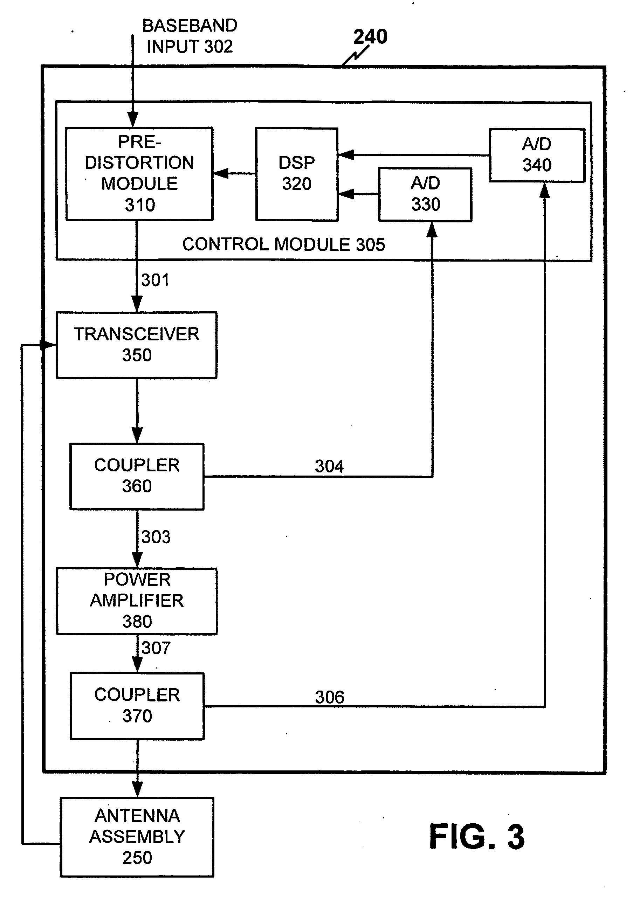

Fig. 3 illustrates a block diagram of a first exemplary implementation of communication interface 240 consistent with the principles of the invention. The implementation of Fig. 3 may include control module 305, transceiver 350, coupler 360, power amplifier 380, and coupler 370.

Control module 305 may include one or more devices to receive a baseband input signal 302 and one or more feedback signals, such as feedback signal 304 or feedback signal 306, and to produce a pre-distorted signal 301 for use by a downstream device, such as transceiver 350. For example, control module 305 may include a pre-distortion module 310, a digital signal processor (DSP) 320, an analog-to-digital converter (A/D) 330 and an analog-to-digital converter (A/D) 340.

Pre-distortion module 310 may include one or more devices to adaptively distort a signal, such as to produce pre-distorted signal 301 by adaptively distorting baseband input signal 302. Pre-distorted signal 301 may be configured to account for changes that a downstream device, such as a power amplifier, applies to a signal as the signal passes from an input of the downstream device to an output of the downstream device. Pre-distortion module 310 may employ hardware based logic, software based logic, or a combination of hardware and software based logic to produce pre-distorted signal 301. Pre-distortion module 310 may be configured to adaptively distort a signal based on feedback information. Implementations of pre-distortion module 310 may adaptively distort a signal in substantially real-time so that the performance of the downstream device (e.g., a power amplifier) is continuously modified to compensate for errors introduced by the downstream device.

Pre-distortion module 310 may receive a baseband input signal 302 that may be in an analog or digital format. For example, in a first implementation, pre-distortion module 310 may receive a baseband analog signal from microphone 150 and in a second implementation, pre-distortion module 310 may receive a digital data stream related to a text message being sent from terminal 100 to a destination device. Implementations of pre-distortion module 310 may operate with or without data structures, e.g. look-up tables, when adaptively pre-distorting an input signal, such as an input signal to power amplifier 380. For example, a first implementation of pre-distortion module 310 may be configured to adaptively modify coefficients related to operating characteristics of an amplifier without employing look-up tables. A second implementation of pre-distortion module 310 may operate with one or more data structures when adaptively modifying pre-distorted signal 301. For example, pre-distortion module 310 may retrieve information from a table, such as a look-up table, and may use the retrieved information to adaptively determine parameters for the pre-distorted signal. Implementations of pre-distorted signal 301 may be configured to cause power amplifier 380 to produce a desired output signal for a given un-distorted input signal, such as baseband input signal 302.

DSP 320 may include one or more devices to process one or more signals. In one implementation, DSP 320 may include logic for processing one or more digital signals that contain information about one or more devices or signals processed by the one or more devices, such as A/D 330. DSP 320 may receive information and/or instructions from a storage device, such as storage 220, and may use the received information when processing the one or more digital signals. DSP 320 may produce a result that can be stored and/or used by another device, such as pre-distortion module 310.

A/D 330 and A/D 340 may include one or more components to convert an analog signal into a digital signal. For example, A/D 330 may receive an analog input signal from a coupler, such as coupler 360, and may produce an output digital signal representative of the amplitude of the input signal. A/D 330 and/or 340 may amplify, attenuate, filter, or frequency shift an input signal in conjunction with producing a digital output signal that represents the input signal. A/D 330 and/or 340 may be implemented in logic having enough speed and dynamic range to adequately sample a frequency range occupied by a transmit burst produced by transceiver 350. For example, A/D 330 and/or 340 may be implemented in logic having a speed sufficient to sample a transmit burst at or above a Nyquist rate related to the transmit burst. Implementations of A/D 330 and/or 340 may also be configured to sub-sample a transmit burst if desired.

Transceiver 350 may include one or more components configured to send and receive information. For example, transceiver 350 may include logic to send information received from pre-distortion module 310 to power amplifier 380 for transmission to a destination via antenna assembly 250. Transceiver 350 may further include logic to receive a signal from antenna assembly 250 and to make the received signal available to a destination, such as another device and/or component operating in terminal 100. In one implementation, transceiver 350 may include logic that modulates a baseband signal using a carrier frequency and/or that demodulates a signal received from antenna assembly 250 to produce a baseband signal.

Coupler 360 and coupler 370 may include devices configured to pass a signal received at an input port to an output port and to make a representation of the passed signal available to a feedback port. For example, coupler 360 or coupler 370 may include logic configured to pass a signal received at the input port to the output port with substantially no attenuation or distortion to the received signal as it passes through coupler 360 or coupler 370. Implementations of coupler 360 or coupler 370 may make an attenuated copy of the passed signal (the feedback signal) available to the feedback port. The feedback port may be adapted to provide the attenuated feedback signal, such as feedback signal 304 or feedback signal 306, to a destination, such as first A/D 330 or second A/D 340, respectively. Coupler 360 may provide feedback signal 304 and coupler 370 may provide feedback signal 306 to a destination device in a manner that does not adversely load a signal at the input port or the output port of coupler 360 or coupler 370, respectively.

Coupler 360 and coupler 370 are examples of a type of logic that can provide a feedback signal to a destination while passing a substantially unaltered signal between an input port and an output port. Other implementations of communication interface 240 may use other types of devices to provide feedback signals to components, such as control module 305. Coupler 360 and coupler 370 may be implemented as standalone components/devices, such as those illustrated in Fig. 3, or may be combined with other devices, such as transceiver 350, power amplifier 380, and/or antenna assembly 250.

Power amplifier 380 may include one or more components that amplify an input signal, such as input signal 303, and make an amplified version of the input signal available to an output. For example, power amplifier 380 may be a solid-state device that receives input signal 303 at an input port and amplifies input signal 303 by a determined amount before making an amplified version of input signal 303 available to an output port or to another device, such as coupler 370 and/or antenna assembly 250, as an output signal 307.

Implementations of power amplifier 380 may provide fixed or variable amplification to an input signal. For example, a first implementation of power amplifier 380 may amplify all input signals by a first amplification value. A second implementation of power amplifier 380 may amplify an input signal having a first frequency by a first amplification value and may amplify an input signal having a second frequency by a second amplification value. Power amplifier 380 may be implemented as a single amplifier, such as via a single stage, and/or may be implemented via multiple amplifiers, such as via two or more cascaded stages. Power amplifier 380 may further include signal conditioning logic, such as filters, frequency shifters, etc.

In the implementation of Fig. 3, power amplifier 380 may have an associated transfer function, h, that can be represented as

$$h(f,\ t,\ \varphi,\ T,\ P) \qquad\qquad \text{EQ. 1}$$

where, $f$ represents frequency, $t$ represents time, $\varphi$ represents phase, $T$ represents temperature and $P$ represents power. Feedback information provided by feedback signals 304, 306 may be used by DSP 320 to produce an inverse transfer function, $h^{-1}$, that may be represented as:

$$h^{-1}(f,\ t,\ \varphi,\ T,\ P) \qquad\qquad \text{EQ. 2}$$

EQ. 2 may represent a desired transfer function for pre-distortion that is applied to baseband input signal 302. Applying $h^{-1}$ to h may be represented as:

$$h(h^{-1}(\ x(f,\ t,\ \varphi,\ T,\ P))) = Kx(f,\ t,\ \varphi,\ T,\ P) \qquad \text{EQ. 3}$$

where, $K$ is a linear amplification factor. $Kx(f,\ t,\ \varphi,\ T,\ P)$ may represent a desired transfer function that produces a desired output signal at an output of power amplifier 380. In other implementations, pre-distortion module 310 may perform the operations of DSP 320.

ALTERNATIVE EXEMPLARY COMMUNICATION INTERFACE

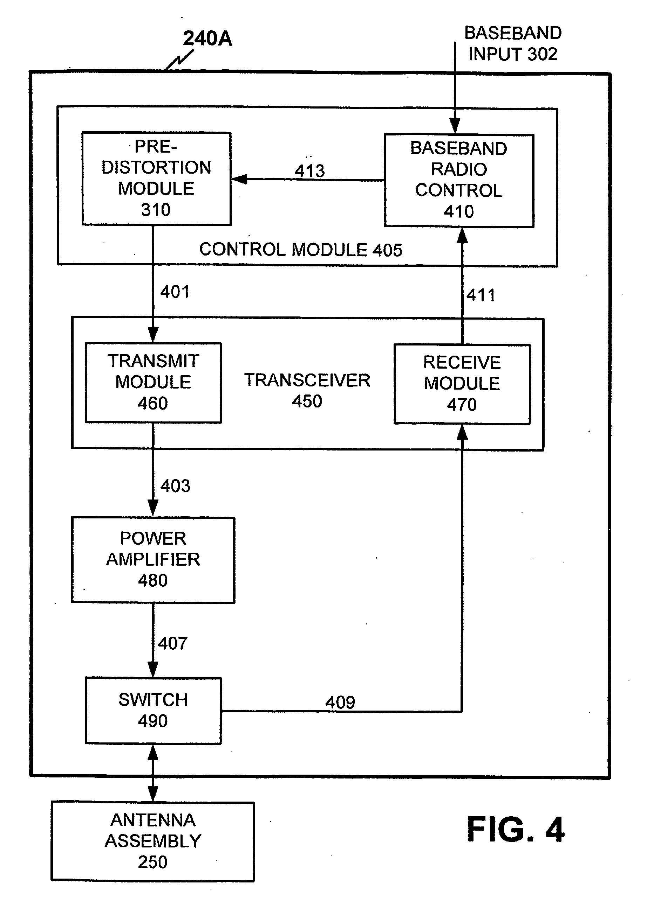

Fig. 4 illustrates a block diagram of a second exemplary implementation of a communication interface 240A consistent with the principles of the invention. Communication interface 240A may include control module 405, transceiver 450, power amplifier 480, and switch 490.

Control module 405 may include one or more components that receive a baseband input signal 302 and produce a pre-distorted input signal 401 that can be made available to a downstream device, such as transceiver 450. In one implementation, control module 405 may include a baseband radio control module 410 and pre-distortion module 310. Pre-distortion module 310 may be configured as described in connection with Fig. 3.

Baseband radio control module 410 may include one or more components that receive baseband input signal 302 and a transceiver feedback signal 411 and produce a signal that can be used by pre-distortion module 310 to produce pre-distorted input signal 401. Baseband radio control module 410 may mix, amplify, attenuate, filter, or frequency shift baseband input signal 302 and/or transceiver feedback signal 411 before making a signal available to pre-distortion module 310.

Transceiver 450 may include a device that receives a baseband signal, such as pre-distorted input signal 401 or a non pre-distorted input signal, and sends a modulated signal 403 to a destination device, such as power amplifier 480, switch 490, or antenna assembly 250.

In one implementation, transceiver 450 may include transmit module 460 and receive module 470. Transmit module 460 may include logic to convert pre-distorted input signal 401 into modulated signal 403. Transmit module 460 may produce one or more types of output signals, such as an output signal for use with a first radio frequency, such as a global system for mobile communications (GSM) band, and another output signal for use with a second radio frequency, such as a second GSM band. In one implementation, transmit module 460 may operate with one or more low noise amplifiers to amplify pre-distorted input signal 401. Transmit module 460 may be configured to work with analog and/or digital signals.

Receive module 470 may include logic to receive a modulated signal at an input port and to produce a demodulated signal at an output port. In one implementation, receive module 470 may be configured to receive a modulated signal that is lower in amplitude than a baseband signal at an input port of transmit module 460 (e.g., pre-distorted input signal 401) and/or a modulated signal at an output port of transmit module 460 (e.g., modulated signal 403). For example, receive module 470 may receive an attenuated/modulated feedback signal 409 from switch 490. The amplitude of feedback signal 409 may be selected so that low noise amplifiers operating in conjunction with transmit module 460 are not adversely affected, such as via crosstalk. Receive module 470 may send a baseband feedback signal 411 to baseband radio control module 410.

Transceiver module 450 may employ an oscillator, or may receive a signal from an oscillator, to produce a modulation frequency for use by components of transceiver 450. For example, transmit module 460 may produce modulated signal 403 using a signal from the oscillator. The modulated signal from the oscillator may also be used by receive module 470 to demodulate a signal received from switch 490 or antenna assembly 250, such as modulated feedback signal 409. Transceiver 450 may be configured to operate transmit module 460 and receive module 470 at substantially the same time so that receive module 470 can produce a signal that can be used to adaptively modify a signal sent from pre-distortion module 310 to transmit module 460.

Power amplifier 480 may be configured and may operate substantially as power amplifier 380 described in connection with Fig. 3, above. In one implementation, power amplifier 480 may be configured to produce an output signal 407 having determined amplitude. Since the amplitude of the output signal 407 is known, an expected signal amplitude at an input port of receive module 470 may be determined.

Switch 490 may include a device to switch between a transmit mode and a receive mode for antenna assembly 250. For example, when terminal 100 is in a transmit mode, switch 490 may make a modulated signal from power amplifier 480 available to antenna assembly 250. In contrast, when terminal 100 is in a receive mode, switch 490 may receive modulated information from antenna assembly 250 and may provide the modulated information to receive module 470. Switch 490 may be configured to provide a representation of a signal passed from an input port of switch 490 to an output port of switch 490 to another device as a feedback signal. For example, in one implementation, switch 490 may send an attenuated representation of a signal sent to antenna assembly 250 to receive module 470 as modulated feedback signal 409.

In one implementation, switch 490 may include a front end module that includes filters and/or amplifiers for selecting one or more frequency bands for use with antenna assembly 250. Switch 490 may be incorporated into communication interface 240A as illustrated in Fig. 4, or may be implemented in antenna assembly 250. Implementations of switch 490 may be electronically controlled, such as to select a frequency band and/or to change from a transmit mode to a receive mode. Alternative implementations of switch 490 may be configured to select one of two or more input signals for use by antenna assembly 250.

The implementation of Fig. 4 may be configured to adaptively compensate substantially the entire radio frequency portion of communication interface 240A. The implementation of communication interface 240A of Fig. 4 may allow for a bit-by-bit comparison of baseband input signal 302 and baseband feedback signal 411 via baseband radio control module 410. In an alternative implementation, baseband radio control module 410 may be configured to perform the comparison in a phase ($I$) and quadrature ($Q$) domain without departing from the spirit and scope of the invention.

The implementation of communication interface 240A of Fig. 4, may be designed to produce a transfer function $h_{RF}$ that may describe the radio frequency portion of communication interface 240A. The transfer function, $h_{RF}$, may be represented by

$$h_{RF}(f,\ t,\ \varphi,\ T,\ P)$$

where, $f$ represents frequency, $t$ represents time, $\varphi$ represents phase, $T$ represents temperature and $P$ represents power. An inverse of $h_{RF}$, that can be represented as $h_{RF}^{-1}$, may be applied to baseband input signal 302 to compensate for errors that may be introduced by the radio frequency portion of communication interface 240A, such as by transceiver 450 and/or or power amplifier 480. The implementation of Fig. 4 may operate with or without look-up tables when adaptively modifying an input signal to power amplifier 480.

EXEMPLARY DATA STRUCTURE

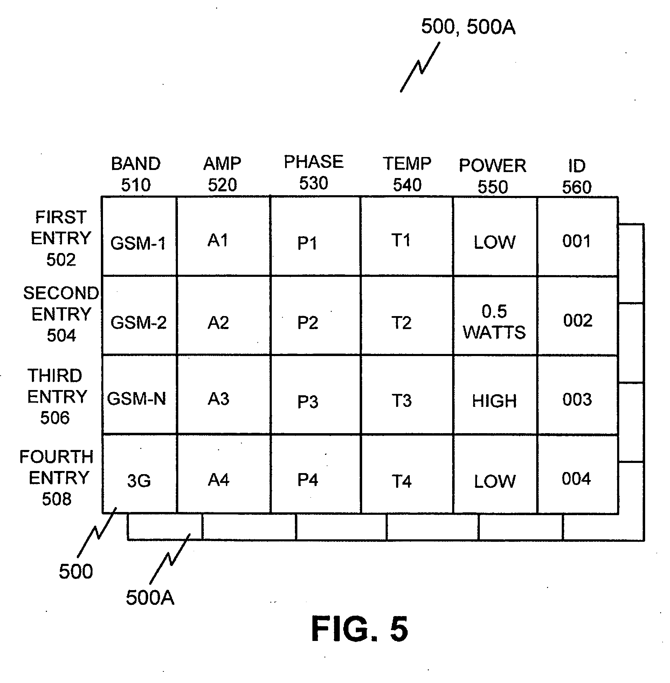

Fig. 5 illustrates an exemplary data structure that can be used to store parameters for power amplifier 380 and/or 480 consistent with the principles of the invention. Data structure 500 may include a computer-readable medium that can be used to store information in a machine-readable format. In an exemplary implementation, data structure 500 may be implemented as a look-up table that includes information that identifies power amplifier parameters that may change as a function of another parameter, such as time, temperature, mode of operation, input frequency, input phase, etc. Implementations of data structure 500 may include information that can be used to adaptively modify an input signal of a device, such as power amplifier 380 and/or 480.

In a first implementation, data structure 500 may include information that identifies how power amplifier 380 and/or 480 should be adaptively driven to produce a desired output (i.e., data structure 500 includes information that takes into account distortion produced by power amplifier 380 and/or 480 for a given entry 502-508). In a second implementation, data structure 500 may include information that identifies parameters related to power amplifier 380 and/or 480 that should be corrected for in order to produce a desired output signal from power amplifier 380 and/or 480 (i.e., the information in data structure 500 does not take into account distortion produced by power amplifier 380 and/or 480 for a given entry 502-508). Information stored in data structure 500/500A may be used to adaptively correct for amplifier distortion at multiple input signal frequencies, input signal amplitudes, input signal phase angles, etc., without requiring that estimation or interpolation be performed with respect to characteristics of power amplifier 380 and/or 480. For example, information in data structure 500/500A may be used to adaptively compensate for amplifier distortion related to bursts, such as transmission bursts, passing through power amplifier 380 and/or 480.

Data structure 500 may include information arranged in fields, such as band field 510, amplitude field 520, phase field 530, temperature field 540, power field 550, and identification (ID) field 560. Information in data structure 500 may be arranged in a row and column format to facilitate interpretation by a user of terminal 100 and/or processing logic 210. Entries 502-508 may be used to identify information associated with band field 510, amplitude field 520, phase field 530, temperature field 540, power field 550, and identification field 560. Data structure 500A may include similar or the same fields as data structure 500.

Implementations of terminal 100 may employ multiple data structures, such as data structure 500 and 500A. For example, when terminal 100 is adapted to operate with multiple communication protocols, such as GSM, third generation wireless (3G), etc., terminal 100 may use a first data structure for GSM (e.g., data structure 500), a second data structure for 3G (e.g., data structure 500A), and other data structures for other communication protocols (not shown in Fig. 5). Alternatively, terminal 100 may employ a first power amplifier and a second power amplifier and may use data structure 500 with the first power amplifier and data structure 500A with the second power amplifier. Implementations of terminal 100 may employ substantially any number of data structures 500 and/or 500A, etc. consistent with the principles of the invention. Implementations of data structure 500 and/or 500A may be updated with new information as needed to facilitate adaptive pre-distortion of input signals to power amplifiers 380 and/or 480. For example, in one implementation, communication interface 240 may be configured to update data structure 500/500A with new information based on a result produced by DSP 320.

Band field 510 may include information that identifies a frequency band over which power amplifier 380 and/or 480 is configured to operate. For example, power amplifier 380 and/or 480, as represented by data structure 500, may be configured to operate with a first GSM band (GSM-1), a second GSM band (GSM-2), an nth GSM band (GSM-n), and a 3G band.

Amplitude field 520 may include an amplitude value or amplitude range that power amplifier 380 and/or 480 is configured to operate with for a given entry 502-508. Amplitude field 502, may include dimensioned values, such as values having units in decibels (dB), volts, etc., or may include dimensionless values, such as values on a scale of one to five or values of low, medium, or high.

Phase field 530 may include a phase value or phase range that power amplifier 380 and/or 480 is configured to operate with or that power amplifier 380 and/or 480 may produce for a given entry 502-508.

Temperature field 540 may include a temperature value or temperature range that is related to an entry 502-508. For example, a value in temperature field 540 may represent a temperature range within which power amplifier 380 and/or 480 is configured to operate, or a value in temperature field 540 may represent a temperature range, or value, that is related to an amount and/or type of distortion related to power amplifier 380 and/or 480.

Power field 550 may include a power value or power range related to an entry 502-508. Values or ranges in power field 550 may be represented in dimensioned values, such as watts, or may be represented dimensionless values, such as low, medium, or high.

ID field 560 may include a reference that can be used to identify an entry 502-508 and/or another data structure, such as data structure 500A, for an implementation of power amplifier 380 and/or 480. Information stored in data structure 500/500A may be used by pre-distortion module 310 to pre-distort input signals prior to processing by downstream devices as described in more detail below.

EXEMPLARY METHOD

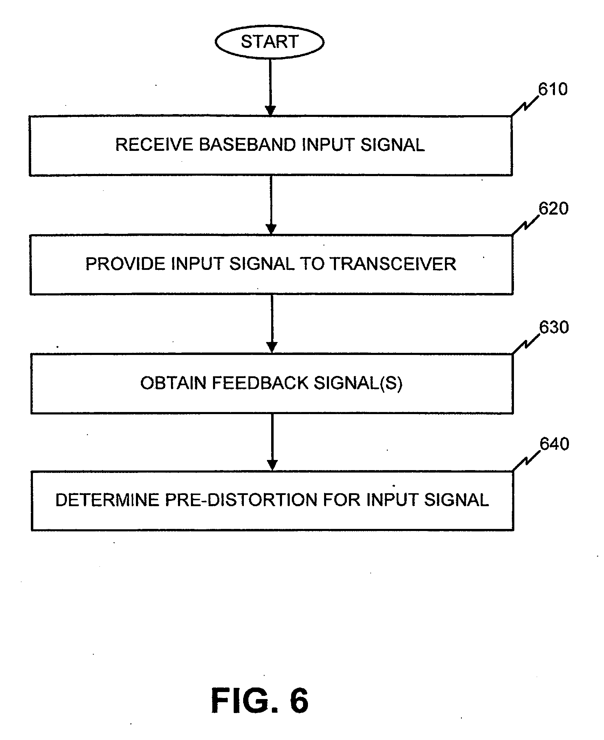

Fig. 6 illustrates exemplary processing that can be used to compensate for distortion, such as power amplifier distortion, consistent with the principles of the invention. Communication interface 240 and/or 240A may receive a baseband input signal, such as baseband input signal 302 (act 610). For example, communication interface 240 and/or 240A may receive an analog or digital input signal from processing logic 210. Baseband input signal 302 may include speech information or data, such as numerical values related to a dialed telephone number. In one implementation, pre-distortion module 310 may receive baseband input signal 302 (e.g., as shown in Fig. 3) and in a second implementation, baseband radio control module 410 may receive baseband input signal 302 (e.g., as shown in Fig. 4). In still other implementations, other components in communication interface 240 and/or 240A may receive baseband input signal 302.

Baseband input signal 302 may be pre-distorted and provided to transceiver 350 and/or 450 (act 620). For example, pre-distortion module 310 may pre-distort baseband input signal 302 to adaptively compensate for operating characteristics of downstream devices, such as transceiver 350 and/or 450 and/or or power amplifier 380 and/or 480.

In one implementation, pre-distortion module 310 may receive a substantially real-time result from DSP 320. The result may represent manipulations to coefficients of an equation that is related to operating characteristics, such as a transfer function, of power amplifier 380 and/or 480. Pre-distortion module 310 may manipulate baseband input signal 302 based on the result to produce a distorted input signal that adaptively compensates for operating characteristics of power amplifier 380 and/or 480. The adaptive compensation of power amplifier 380 and/or 480 may be performed in substantially real-time using an implementation consistent with the principles of the invention.

In another implementation, pre-distortion module 310 may receive a result from DSP 320. Pre-distortion module 310 may retrieve information from data structure 500/500A and may use the retrieved information and the result from DSP 320 to adaptively distort baseband input signal 302. For example, pre-distortion module 310 may retrieve information about temperature, amplitude, phase, and/or other amplifier parameters from data structure 500/500A. Pre-distortion module 310 may use the retrieved parameters when adaptively distorting baseband input signal 302.

In still another implementation, pre-distortion module 310 may load information into data structure 500/500A based on a type of pre-distortion applied to baseband input signal 302. For example, pre-distortion module 310 may dynamically update data structure 500/500A with a temperature value, an amplitude value, a phase value, etc. based on pre-distortion applied to baseband input signal 302. Pre-distortion module 310 may use information from data structure 500/500A to adaptively process subsequent baseband input signals 302 without receiving new results from DSP 320 as long as operating parameters for amplifier 380 are within a range that is related to information in data structure 500/500A. When parameters for amplifier 380 exceed the range related to information stored in data structure 500/500A, pre-distortion module 310 may receive a new result from DSP 320 and may use the new result to adaptively distort baseband input signal 302. Pre-distortion module 310 may update data structure 500/500A with new values related to distortion applied to baseband input signal 302. The new values may be used by pre-distortion module 310 when adaptively manipulating baseband input signals 302 that are within a range related to the new values in data structure 500/500A.

Pre-distortion module 310 may provide an adaptively pre-distorted baseband input signal to downstream devices. The downstream devices may be configured to produce an output signal in response to an input signal. Implementations of communication interface 240 and/or 240A may use a representation of an output signal produced by downstream devices as a feedback signal that can be used to adaptively pre-distort a baseband input signal, such as baseband input signal 302.

For example, a feedback signal may be obtained via logic, such as coupler 360, coupler 370, or via a signal obtained from a receive module 470 (act 630). The feedback signal may represent a signal associated with a device, such as power amplifier 380 and/or 480. For example, in a first implementation, such as shown in Fig. 3, feedback signal 304 may be obtained via coupler 360 and may represent a signal at an input of power amplifier 380, such as input signal 303. The first implementation, may further obtain a second feedback signal via coupler 370 that represents a signal at an output of power amplifier 380, such as output signal 307. For example, couplers 360/370 may provide feedback information to pre-distortion module 310 via a feedback port while passing a signal present at an input port of the coupler to an output port of the coupler. Feedback signal 304 and feedback signal 306 may be used to determine an error associated with amplifier 380, i.e., a difference between the characteristics of input signal 303 and the characteristics of output signal 307.

Implementations may adaptively modify coefficients, such as coefficients in equations that may represent performance characteristics of power amplifier 380 or 480. Feedback signals, such as feedback signal 304, 306, and 409, can be used to modify the coefficients in substantially real-time. As a result, feedback signals 304, 306, and 409 can be used to continuously modify the performance of power amplifier 380 or 480 to obtain a desired signal at the output of power amplifier 380 or 480.

Feedback signal 304 and feedback signal 306 may be sampled using A/D 330 and A/D 340, respectively, and processed using DSP 320. DSP 320 may determine adaptive coefficients for the updated distortion function that can be applied to baseband input signal 302 to produce a desired pre-distorted signal 301 (act 640). For example, DSP 320 may produce an error signal that is related to distortion produced by power amplifier 380. The error signal may be sent to pre-distortion module 310. Pre-distortion module 310 may use the error signal to produce a pre-distorted signal based on baseband input signal 302. For example, pre-distortion module 310 may produce a pre-distorted input signal 301 using a transfer function $h^{-1}(f, t, \varphi, T, P)$ that is configured to produce a transfer function $Kx(f, t, \varphi, T, P)$ when applied to power amplifier 380 having a transfer function represented by $h(f, t, \varphi, T, P)$. Transfer function $Kx(f\ t, \varphi, T, P)$ may represent a substantially ideal transfer function for power amplifier 380 that produces an output signal that is amplified by a factor $K$ and is also substantially distortion free.

Pre-distortion module 310 may send pre-distorted input signal 301 to a downstream device, such as transceiver 350 and/or power amplifier 380. Pre-distorted input signal 301 may be configured to adaptively compensate for errors, such as signal distortion, introduced by one or more of the downstream devices. Implementations may adaptively modify pre-distorted input signal 301 in a similar manner using other feedback signals, as described above.

The second implementation of a communication interface, such as communication interface 240A, may use feedback to adaptively pre-distort a baseband input signal that takes into account distortion that may be imparted by a transceiver. For example, a transceiver, such as transceiver 450, may include a transmit module 460 and a receive module 470. Transmit module 460 may receive a baseband signal and may modulate the baseband signal before sending the modulated signal, e.g., modulated signal 403, to a power amplifier, such as power amplifier 480. A switch, such as switch 490, may be configured to receive an output signal 407 from power amplifier 480 and to send the received signal to antenna assembly 250 when switch 490 is in a transmit mode. Switch 490 may further be configured to provide a modulated feedback signal 409 to a destination, such as receive module 470, operating in transceiver 450. Modulated feedback signal 409 may be attenuated with respect to a signal at an input port of switch 490 or with respect to a signal at an output port of transmit module 460 to eliminate crosstalk between transmit module 460 and receive module 470.

Receive module 470 may provide a demodulated feedback signal 411 to baseband radio control module 410. Baseband radio control module 410 may operate on baseband input signal 302 and baseband feedback signal 411 to produce a result. For example, baseband radio control module 410 may perform a bit by bit comparison between baseband input signal 302 and demodulated feedback signal 411 from receive module 470. Baseband radio control module 410 may provide a modified baseband input signal 413 to pre-distortion module 310 or may provide baseband signal 302 and error information to pre-distortion module 310.

Pre-distortion module 310 may produce a signal that, when applied to transmit module 460, has the effect of modifying a transfer function, $h_{RF}(f, t, \varphi, T, P)$, associated with the downstream components for the radio frequency portion of communication interface 240A by applying a transfer function that can be represented by $h_{RF}^{-1}(f, t, \varphi, T, P)$ to produce a desired transfer function of $Kx(f, t, \varphi, T, P)$. The desired transfer function, $Kx(f, t, \varphi, T, P)$, may be configured to produce a desired signal at an input of antenna assembly 250. The desired input signal may be configured to have K amplification and little to no distortion.

CONCLUSION

Implementations consistent with the principles of the invention may facilitate adaptively compensating for characteristics of power amplifiers or other types of electronic components, such as buffers, filters, frequency shifters, etc., operating in a host device, such as a communications device, an appliance, an industrial system, etc. Implementations may obtain a feedback signal that is used to pre-distort an input signal to the power amplifier. The pre-distorted input signal may be configured to adaptively compensate for characteristics of the power amplifier. Adaptively compensating for power amplifier characteristics may produce a desired output signal, such as an undistorted output signal, at the output of the power amplifier. Implementations consistent with the principles of the invention may, or may not, use data structures (e.g., look-up tables) to adaptively compensate for power amplifier characteristics.

The foregoing description of preferred embodiments of the invention provides illustration and description, but is not intended to be exhaustive or to limit the invention to the precise form disclosed. Modifications and variations are possible in light of the above teachings or may be acquired from practice of the invention.

For example, the implementations described above refer to pre-distorting an input signal. In some implementations, the signals may be distorted after processing by other devices. In each case, the distortion applied will essentially cancel the distortion from the normal processing components. While a series of acts has been described with regard to Fig. 6, the order of the acts may be modified in other implementations consistent with the principles of the invention. Further, non-dependent acts may be performed in parallel.

It will be apparent to one of ordinary skill in the art that aspects of the invention, as described above, may be implemented in many different forms of software, firmware, and hardware in the implementations illustrated in the figures. The actual software code or specialized control hardware used to implement aspects consistent with the principles of the invention is not limiting of the invention. Thus, the operation and behavior of the aspects were described without reference to the specific software code--it being understood that one of ordinary skill in the art would be able to design software and control hardware to implement the aspects based on the description herein.

Further, certain portions of the invention may be implemented as "logic" that performs one or more functions. This logic may include hardware, such as hardwired logic, an application specific integrated circuit, a field programmable gate array, a microprocessor, software, or a combination of hardware and software.

It should be emphasized that the term "comprises/comprising" when used in this specification and/or claims is taken to specify the presence of stated features, integers, steps or components but does not preclude the presence or addition of one or more other features, integers, steps, components or groups thereof.

No element, act, or instruction used in the present application should be construed as critical or essential to the invention unless explicitly described as such. Also, as used herein, the article "a" is intended to include one or more items. Where only one item is intended, the term "one" or similar language is used. Further, the phrase "based on" is intended to mean "based, at least in part, on" unless explicitly stated otherwise.

**Claims**

1. A device (100), comprising:

   a baseband radio control module (410) configured to receive a baseband input signal comprising a plurality of bits;
   a distortion module (310) coupled to the baseband radio control module and configured to receive the baseband input signal;
   a transceiver (450) coupled to the distortion module, the transceiver comprising:

      a receive module (470) configured to receive and process input signals transmitted to the device from other devices, and
      a transmit module (460) configured to:

         receive the baseband input signal, and
         generate a modulated baseband input signal; and

   an amplifier (480) to:

      receive the modulated baseband input signal, and
      generate an amplified signal;
      wherein the receive module (470) is further configured to:
      receive a feedback signal corresponding to the amplified signal, and
      generate a demodulated feedback signal;
      wherein the baseband radio control module (410) is further configured to:
      receive the demodulated feedback signal,
      compare the baseband input signal and the demodulated feedback signal on a bit by bit basis, and
      provide error information to the distortion module based on the bit by bit comparison,
      wherein the distortion module (310) is further configured to:
      receive the error information,
      retrieve information from a table (500, 500A) to identify amplifier parameters that change as a function of other parameters, the table including information associated with a number of different communication protocols, wherein the table is periodically updated to account for changes in characteristics of the amplifier;
      modify the baseband input signal based on the error information and based on the retrieved information, and
      send the modified baseband input signal to the transceiver for output from the device via an antenna assembly (250).

2. The device (100) of claim 1, further comprising
   an oscillator to:

      provide modulation information to the transmit module for use in generating the modulated baseband input signal, and
      provide demodulation information to the receive module for use in producing the demodulated feedback signal.

3. The device (100) of claim 1, wherein the amplified signal is distorted with respect to the modulated baseband input signal.

4. The device (100) of claim 3, wherein the distorted input signal is configured to produce a desired amplified signal when the modulated baseband input signal is amplified by the amplifier.

5. The device (100) of claim 1, wherein the transceiver (450) has transceiver characteristics and the amplifier has amplifier characteristics, and wherein the modified baseband input signal is adapted to produce a desired amplified signal based on the transceiver characteristics and the amplifier characteristics.

6. The device of claim 1, further comprising:

   a switch (490) to:

      receive the amplified signal,
      send the amplified signal to the antenna assembly, and
      provide an attenuated representation of the amplified signal to the receive module as the feedback signal.

7. A method for compensating for distortion in a device, the method comprising:

   receiving an input signal;
   forwarding the input signal through a transmit module (460) of a transceiver and through an amplifier (480);
   receiving, by a receive module (470) of the transceiver, a modulated feedback signal output from the amplifier;
   generating, by the receive module (470), a demodulated feedback signal;
   performing a bit by bit comparison of the demodulated feedback signal and the input signal;
   retrieving information from a table (500, 500A) to identify amplifier parameters that change as a function of other parameters, the table including information associated with a number of different communication protocols, wherein the table is periodically updated to account for changes in characteristics of the amplifier;
   generating distortion information based on the comparison; and
   using the distortion information and the retrieved information to modify the input signal and generate a desired output signal at an output of the amplifier.

8. The method of claim 7, wherein the receiving the modulated feedback signal comprises:

   receiving information associated with transceiver characteristics and amplifier characteristics via the modulated feedback signal.

9. The method of claim 7, wherein the generating distortion information comprises:

   identifying information related to characteristics of the amplifier; and
   applying the distortion information to the amplifier or to devices associated with the amplifier to produce the desired output signal, where the desired output signal compensates for characteristics of the amplifier.

10. The method of claim 7, wherein the generating distortion information comprises:

   identifying information associated with a first transfer function representing characteristics of the amplifier and the transceiver operating with the amplifier; and
   identifying information associated with a second transfer function that is an inverse transfer function with respect to the first transfer function.

**Patentansprüche**

1. Eine Vorrichtung (100) umfassend:

   ein Basisbandfunkkontrollmodul (410), welches konfiguriert ist, ein Basisbandeingangssignal zu empfangen, welches eine Vielzahl an Bits umfasst;
   ein Verzerrungsmodul (310), welches mit dem Basisbandfunkkontrollmodul verbunden ist und konfiguriert ist, das Basisbandeingangssignal zu empfangen;
   ein Sendeempfänger (450), welcher mit dem Verzerrungsmodul verbunden ist, wobei der Sendeempfänger umfasst:

12

ein Empfangsmodul (470), welches konfiguriert ist, Eingangssignale, die zu der Vorrichtung von anderen Vorrichtungen gesendet werden, zu empfangen und zu verarbeiten, und
ein Sendemodul (460), welches konfiguriert ist:

das Basisbandeingangssignal zu empfangen, und
ein moduliertes Basisbandeingangssignal zu generieren; und

einen Verstärker (480) zum:

Empfangen des modulierten Basisbandeingangssignals, und
Generieren eines verstärkten Signals;
wobei das Empfangsmodul (470) weiterhin konfiguriert ist:
ein dem verstärkten Signal entsprechendes Rückkopplungssignal zu empfangen, und
ein demoduliertes Rückkopplungssignal zu generieren;
wobei das Basisbandfunkkontrollmodul (410) weiterhin konfiguriert ist:
das demodulierte Rückkopplungssignal zu empfangen,
das Basisbandeingangssignal und das demodulierte Rückkopplungssignal auf einer Bit-für-Bit-Basis zu vergleichen, und
dem Verzerrungsmodul eine auf dem Bit-für-Bit-Vergleich basierende Fehlerinformation bereitzustellen, wobei das Verzerrungsmodul (310) weiterhin konfiguriert ist:
die Fehlerinformation zu empfangen,
Information von einer Tabelle (500, 500A) abzufragen, um Verstärkerparameter, die sich als Funktion von anderen Parametern verändern, zu identifizieren, wobei die Tabelle Information beinhaltet, die zu einer Anzahl verschiedener Kommunikationsprotokolle gehört, wobei die Tabelle periodisch aktualisiert wird, um Veränderungen von Eigenschaften des Verstärkers zu berücksichtigen;
das Basisbandeingangssignal basierend auf der Fehlerinformation und basierend auf der abgefragten Information zu modifizieren, und
das modifizierte Basisbandeingangssignal an den Sendeempfänger zur Ausgabe aus der Vorrichtung mittels einer Antennenanordnung (250) zu senden.

2. Die Vorrichtung (100) nach Anspruch 1, weiterhin umfassend
einen Oszillator, um:

dem Sendemodul Modulationsinformation zur Verwendung bei der Erzeugung des modulierten Basisbandeingangssignals bereitzustellen, und
dem Empfangsmodul Demodulierungsinformation zur Verwendung in der Erstellung des demodulierten Rückkopplungssignals bereitzustellen.

3. Die Vorrichtung (100) nach Anspruch 1, wobei das verstärkte Signal in Bezug auf das modulierte Basisbandeingangssignal verzerrt ist.

4. Die Vorrichtung (100) nach Anspruch 3, wobei das verzerrte Eingangssignal konfiguriert ist, ein erwünschtes verstärktes Signal zu erstellen, wenn das modulierte Basisbandeingangssignal von dem Verstärker verstärkt ist.

5. Die Vorrichtung (100) nach Anspruch 1, wobei der Sendeempfänger (450) Sendeempfängereigenschaften hat und der Verstärker Verstärkereigenschaften hat, und wobei das modifizierte Basisbandeingangssignal ausgestaltet ist, ein erwünschtes verstärktes Signal basierend auf den Sendeempfängereigenschaften und den Verstärkereigenschaften zu erstellen.

6. Die Vorrichtung nach Anspruch 1, weiterhin umfassend:

einen Schalter (490), um:

das verstärkte Signal zu empfangen,
das verstärkte Signal zu der Antennenanordnung zu senden, und
eine gedämpfte Darstellung des verstärkten Signals dem Empfangsmodul als das Rückkopplungssignal bereitzustellen.

**7.** Ein Verfahren zum Kompensieren von Verzerrung in einer Vorrichtung, wobei das Verfahren umfasst:

Empfangen eines Eingangssignals;

Weiterleiten des Eingangssignals durch ein Sendemodul (460) eines Sendeempfänger und durch einen Verstärker (480) ;

Empfangen eines modulierten Rückkopplungssignals, welches von dem Verstärker ausgegeben wurde, mittels eines Empfangsmoduls (470) des Sendeempfängers;

Erzeugen eines demodulierten Rückkopplungssignals mittels des Empfangsmoduls (470),

Durchführen eines Bit-für-Bit-Vergleichs des demodulierten Rückkopplungssignals und des Eingangssignals;

Abfragen von Information von einer Tabelle (500, 500A), um Verstärkerparameter, die sich als Funktion von anderen Parametern verändern, zu identifizieren, wobei die Tabelle Information beinhaltet, die zu einer Anzahl verschiedener Kommunikationsprotokolle gehört, wobei die Tabelle periodisch aktualisiert wird, um Veränderungen von Eigenschaften des Verstärkers zu berücksichtigen;

Erzeugen von Verzerrungsinformation basierend auf dem Vergleich; und

Verwenden der Verzerrungsinformation und der abgefragten Information, um das Eingangssignal zu modifizieren und ein erwünschtes Ausgangssignal an einem Ausgang des Verstärkers zu erzeugen.

**8.** Das Verfahren nach Anspruch 7, wobei das Empfangen des modulierten Rückkopplungssignals umfasst:

Empfangen von Information mittels des modulierten Rückkopplungssignals, welche zu Sendeempfängereigenschaften und Verstärkereigenschaften gehört.

**9.** Das Verfahren nach Anspruch 7, wobei das Erzeugen von Verzerrungsinformation umfasst:

Identifizieren von Information bezüglich der Eigenschaften des Verstärkers; und

Anwendung von der Verzerrungsinformation auf den Verstärker oder auf Vorrichtungen, die zu dem Verstärker gehören, um das erwünschte Ausgangssignal zu erstellen, wobei das erwünschte Ausgangssignal Eigenschaften des Verstärkers kompensiert.

**10.** Das Verfahren nach Anspruch 7, wobei das Erzeugen von Verzerrungsinformation umfasst:

Identifizieren von Information, die zu einer ersten Transferfunktion gehört, welche Eigenschaften des Verstärkers und des Sendeempfängers, der mit dem Verstärker arbeitet, repräsentiert; und

Identifizieren von Information, die zu einer zweiten Transferfunktion gehört, welche in Bezug auf die erste Transferfunktion eine inverse Transferfunktion ist.

**Revendications**

**1.** Dispositif (100), comprenant :

un module (410) de radiocommande en bande de base configuré pour recevoir un signal d'entrée en bande de base comprenant une pluralité de bits ;

un module de distorsion (310) couplé au module de radiocommande en bande de base et configuré pour recevoir le signal d'entrée en bande de base ;

un émetteur-récepteur (450) couplé au module de distorsion, l'émetteur-récepteur comprenant :

un module de réception (470) configuré pour recevoir et traiter des signaux d'entrée transmis au dispositif des autres dispositifs, et

un module d'émission (460) configuré pour :

recevoir le signal d'entrée en bande de base, et

générer un signal d'entrée en bande de base modulé ;

et

un amplificateur (480) pour :

recevoir le signal d'entrée en bande de base modulé,

et

générer un signal amplifié ;

dans lequel le module de réception (470) est en outre configuré pour :

recevoir un signal de retour correspondant au signal amplifié, et

générer un signal de retour démodulé ;

dans lequel le module (410) de radiocommande en bande de base est configuré en outre pour :

recevoir le signal de retour démodulé ;

comparer le signal d'entrée en bande de base et le signal de retour démodulé bit par bit, et

fournir un information d'erreur au module de distorsion sur la base d'une comparaison bit par bit,

dans lequel le module de distorsion (310) est configuré en outre pour :

recevoir l'information d'erreur,

récupérer une information à partir d'un tableau (500, 500A) pour identifier des paramètres de l'amplificateur qui changent en fonction d'autres paramètres, le tableau comprenant des informations associées avec un nombre de protocoles de communication différents, dans lequel le tableau est périodiquement mis à jour pour prendre en compte des changements au niveau des caractéristiques de l'amplificateur ;

modifier le signal d'entrée en bande de base sur la base de l'information d'erreur et sur la base de l'information récupérée, et

envoyer le signal d'entrée en bande de base modifié à l'émetteur-récepteur pour le délivrer en sortie du dispositif par l'intermédiaire d'un ensemble d'antennes (250) .

2. Dispositif (100) de la revendication 1, comprenant en outre :

un oscillateur pour :

fournir une information de modulation au module d'émission à utiliser pour la génération du signal d'entrée en bande de base modulé, et

fournir une information de démodulation au module de réception à utiliser pour la production du signal de retour démodulé.

3. Dispositif (100) de la revendication 1, dans lequel le signal amplifié est distordu par rapport au signal d'entrée en bande de base modulé.

4. Dispositif (100) de la revendication 3, dans lequel le signal d'entrée distordu est configuré pour produire un signal amplifié désiré lorsque le signal d'entrée en bande de base modulé est amplifié par l'amplificateur.

5. Dispositif (100) de la revendication 1, dans lequel l'émetteur-récepteur (450) a des caractéristiques d'émetteur-récepteur et l'amplificateur a des caractéristiques d'amplificateur, et dans lequel le signal d'entrée en bande de base modifié est adapté pour produire un signal amplifié désiré sur la base des caractéristiques de l'émetteur-récepteur et des caractéristiques de l'amplificateur.

6. Dispositif de la revendication 1, comprenant en outre :

un commutateur (490) pour :

recevoir le signal amplifié,

envoyer le signal amplifié à l'ensemble d'antennes, et

fournir une représentation atténuée du signal amplifié au module récepteur en tant que signal de retour.

7. Procédé destiné à compenser une distorsion dans un dispositif, le procédé comprenant le fait :

de recevoir un signal d'entrée ;

de transférer le signal d'entrée à travers un module d'émission (460) d'un émetteur-récepteur et à travers un amplificateur (480) ;

de recevoir, par un module de réception (470) de l'émetteur-récepteur, un signal de retour modulé délivré en sortie de l'amplificateur ;

de générer, par un module de réception (470), un signal de retour démodulé ;

de réaliser une comparaison bit par bit du signal de retour démodulé et du signal d'entrée ;

de récupérer une information à partir d'un tableau (500, 500A) pour identifier des paramètres d'amplificateur qui changent en fonction d'autres paramètres, le tableau comprenant des informations associées à un nombre des différents protocoles de communication, dans lequel le tableau est périodiquement mis à jour pour prendre en compte des changements au niveau des caractéristiques de l'amplificateur ;

de générer une information de distorsion sur la base de la comparaison ; et

d'utiliser l'information de distorsion et l'information récupérée pour modifier le signal d'entrée et générer un signal de sortie désiré au niveau d'une sortie de l'amplificateur.

8. Procédé de la revendication 7, dans lequel la réception du signal de retour modulé comprend le fait :

de recevoir une information associée avec les caractéristiques de l'émetteur-récepteur et les caractéristiques de l'amplificateur par l'intermédiaire du signal de retour modulé.

9. Procédé de la revendication 7, dans lequel la génération d'information de distorsion comprend le fait :

d'identifier une information relative aux caractéristiques de l'amplificateur ; et
d'appliquer l'information de distorsion à l'amplificateur ou à des dispositifs associés avec l'amplificateur pour produire le signal de sortie désiré, où le signal de sortie désiré compense les caractéristiques de l'amplificateur.

10. Procédé de la revendication 7, dans lequel la génération d'information de distorsion comprend le fait :

d'identifier une information associée avec une première fonction de transfert représentant les caractéristiques de l'amplificateur et de l'émetteur-récepteur fonctionnant avec l'amplificateur ; et
d'identifier une information associée avec une deuxième fonction de transfert qui est une fonction de transfert inverse par rapport à la première fonction de transfert.

**FIG. 1**

FIG. 2

BASEBAND
INPUT 302

**240**

PRE-
DISTORTION
MODULE
310

DSP
320

A/D
330

A/D
340

CONTROL MODULE 305

301

TRANSCEIVER
350

COUPLER
360

304

303

POWER
AMPLIFIER
380

307

COUPLER
370

306

ANTENNA
ASSEMBLY
250

# FIG. 3

**240A**

BASEBAND
INPUT 302

CONTROL MODULE 405

PRE-
DISTORTION
MODULE
310

413

BASEBAND
RADIO
CONTROL
410

401

411

TRANSMIT
MODULE
460

TRANSCEIVER
450

RECEIVE
MODULE
470

403

POWER
AMPLIFIER
480

407

SWITCH
490

409

ANTENNA
ASSEMBLY
250

FIG. 4

500, 500A

| | BAND 510 | AMP 520 | PHASE 530 | TEMP 540 | POWER 550 | ID 560 |
|---|---|---|---|---|---|---|
| FIRST ENTRY 502 | GSM-1 | A1 | P1 | T1 | LOW | 001 |
| SECOND ENTRY 504 | GSM-2 | A2 | P2 | T2 | 0.5 WATTS | 002 |
| THIRD ENTRY 506 | GSM-N | A3 | P3 | T3 | HIGH | 003 |
| FOURTH ENTRY 508 | 3G | A4 | P4 | T4 | LOW | 004 |

500

500A

# FIG. 5

START

610

RECEIVE BASEBAND INPUT SIGNAL

620

PROVIDE INPUT SIGNAL TO TRANSCEIVER

630

OBTAIN FEEDBACK SIGNAL(S)

640

DETERMINE PRE-DISTORTION FOR INPUT SIGNAL

# FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0105026 A